Europäisches Patentamt

(19) European Patent Office

Office européen des brevets

(11) Numéro de publication : **0 073 699**
**B1**

# (12) FASCICULE DE BREVET EUROPÉEN

(45) Date de publication du fascicule du brevet :
30.10.85

(21) Numéro de dépôt : 82401462.5

(22) Date de dépôt : 03.08.82

(51) Int. Cl.⁴ : **H 03 C 3/09, H 03 L 7/18,
H 04 L 27/12**

(54) **Synthétiseur de fréquences à division fractionnaire, utilisé pour une modulation angulaire numérique.**

(30) Priorité : 17.08.81 FR 8115808

(43) Date de publication de la demande :
09.03.83 Bulletin 83/10

(45) Mention de la délivrance du brevet :
30.10.85 Bulletin 85/44

(84) Etats contractants désignés :
DE GB IT

(56) Documents cités :
FR-A- 2 454 219
GB-A- 1 560 233
US-A- 4 068 199
ELECTRONIC COMPONENTS & APPLICATIONS, vol.
3, no. 1, novembre 1980, pages 47-61, Eindhoven
(NL); P.R. BRENNAND et al.: "Frequency synthesiser
using LSI devices"
PATENTS ABSTRACTS OF JAPAN, vol. 5, no. 109, 15
juillet 1981, page E-65, 781;

(73) Titulaire : THOMSON-CSF
173, Boulevard Haussmann
F-75379 Paris Cedex 08 (FR)

(72) Inventeur : Albarello, Alain
THOMSON-CSF SCPI 173, bld Haussmann
F-75379 Paris Cedex (FR)
Inventeur : Roullet, André
THOMSON-CSF SCPI 173, bld Haussmann
F-75379 Paris Cedex (FR)
Inventeur : Pimentel, Alberto
THOMSON-CSF SCPI 173, bld Haussmann
F-75379 Paris Cedex (FR)

(74) Mandataire : Courtellemont, Alain et al
THOMSON-CSF SCPI 173, Bld Haussmann
F-75379 Paris Cedex 08 (FR)

## Description

La présente invention se rapporte à un synthétiseur de fréquences à division fractionnaire utilisé pour l'obtention d'un signal à modulation angulaire.

Le synthétiseur de fréquences à division fractionnaire est connu, par exemple du document GB-A-1 560 233 ; il est destiné à fournir un signal de sortie de la forme $F_S = (N + k)F_R$ où N est la partie entière d'un nombre $N + k$ et $F_R$ la fréquence d'un signal de référence. Il comporte : un oscillateur variable — une boucle d'asservissement de l'oscillateur variable, comprenant en série : un diviseur à rang variable prépositionné sur le rang de division N, un comparateur de la phase du signal de sortie du diviseur avec celle du signal de référence, un sommateur et un filtre — et un accumulateur de phase constitué d'un circuit d'addition et d'un registre tampon qui, à la fréquence $F_R$, somme modulo M le nombre $G = k \cdot M$ et qui a ses sorties de somme et de retenue respectivement couplées au sommateur pour fournir un signal de compensation et au diviseur pour fournir un signal de commande à $N + 1$ du rang de division et un additionneur ayant une sortie couplée à l'entrée de l'accumulateur de phase, cet additionneur recevant un nombre constant g sur une entrée et un nombre dg représentatif d'une information numérique sur une autre entrée.

Dans les synthétiseurs connus de ce type, le nombre dg est une valeur de correction permettant, par exemple dans un récepteur de radio, de faire un verrouillage de phase de l'oscillateur local, constitué par le synthétiseur, sur le signal reçu.

Quand un tel synthétiseur de fréquences doit être associé à un modulateur de signaux numériques pour fournir un signal modulé de façon angulaire par des informations numériques, il est connu de placer le modulateur dans la boucle d'asservissement ou à la sortie du synthétiseur de fréquences. Lorsque le modulateur est placé dans la boucle d'asservissement, entre le sommateur et l'entrée de commande de l'oscillateur variable, la boucle d'asservissement se comportant comme un filtre passe-haut pour les signaux de modulation qui sont appliqués à l'entrée de commande de l'oscillateur variable, il n'y a pas possibilité de transmettre les composantes basse-fréquence de l'information numérique. Une autre façon de faire qui élimine le problème de bande passante de boucle, est de réaliser un modulateur angulaire à fréquence fixe à l'aide d'un oscillateur à quartz contrôlé en tension, le signal issu de celui-ci étant ajouté au signal du synthétiseur de fréquence au moyen d'un mélange suivi d'un filtrage pour éliminer les produits de mélange indésirables ; ce procédé est coûteux en particulier parce que entièrement analogique. Dans chaque cas, il est nécessaire de placer un filtre analogique à l'entrée du modulateur pour limiter le spectre du signal modulé.

La présente invention a pour but d'éviter tout ou partie des inconvénients précités en proposant d'utiliser un synthétiseur de fréquences à division fractionnaire de manière telle que la modulation angulaire numérique soit effectuée par le synthétiseur même.

Ceci est obtenu par une commande convenable du synthétiseur en fonction du signal modulant.

Selon l'invention, un synthétiseur de fréquences à division fractionnaire pour fournir un signal de sortie de la forme $F_S = (N + k)F_R'$ où N est la partie entière d'un nombre $N + k$ et $F_R$ la fréquence d'un signal de référence, comportant : un oscillateur variable ; une boucle d'asservissement de l'oscillateur variable, comprenant, en série, un diviseur à rang variable prépositionné sur le rang de division N, un comparateur de la phase du signal de sortie du diviseur avec celle du signal de référence, un sommateur et un filtre ; un accumulateur de phase, constitué d'un additionneur et d'un registre tampon, pour, à la fréquence $F_R$, somme modulo M un nombre $G = k \cdot M$ appliqué sur son entrée, et dont les sorties de somme et de retenue sont respectivement couplées au sommateur pour fournir un signal de compensation, et au diviseur pour fournir un signal de commande à $N + 1$ du rang de division ; et un additionneur ayant une sortie couplée à l'entrée de l'accumulateur de phase, cet additionneur recevant un nombre constant g sur une entrée et un nombre dg représentatif d'une information numérique sur une autre entrée, est caractérisé en ce que, pour que le synthétiseur soit aussi le modulateur d'un émetteur à modulation angulaire, modulé par une information numérique, le nombre dg est une information numérique à émettre.

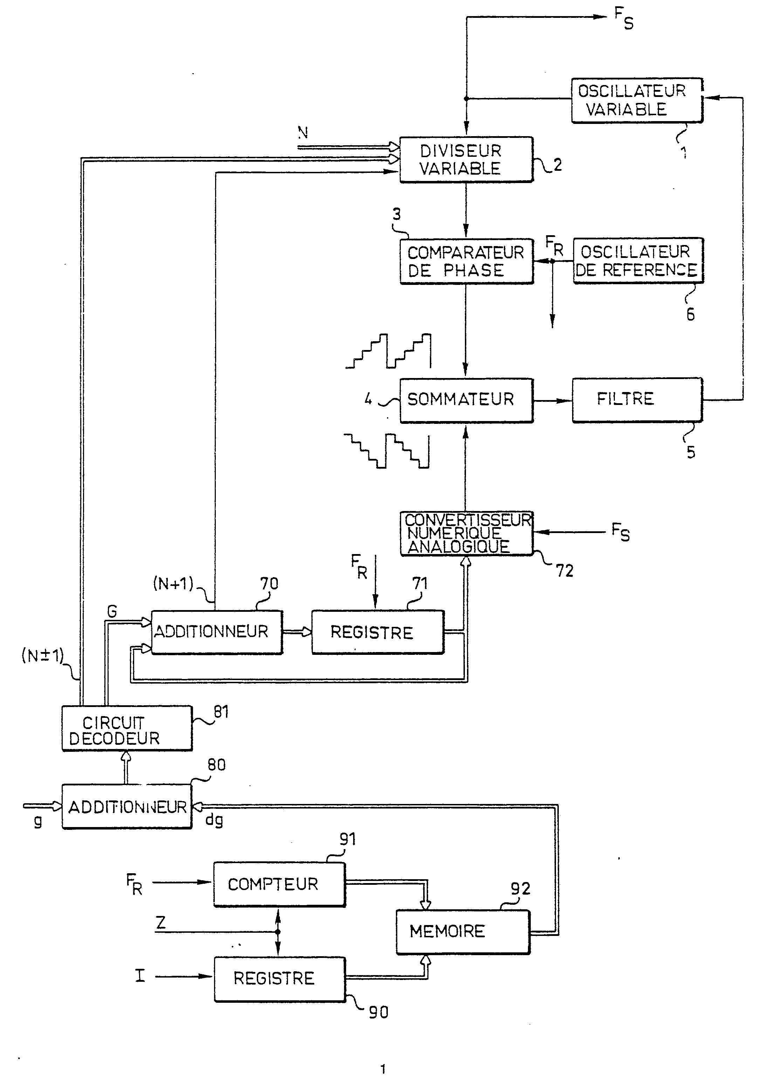

La présente invention sera mieux comprise et d'autres caractéristiques apparaîtront à l'aide de la description ci-après et la figure s'y rapportant qui représente un synthétiseur de fréquences selon l'invention.

Dans la description et dans les revendications, il sera dit, à plusieurs endroits, par souci de simplification qu'un circuit reçoit ou fournit un nombre, cela signifie bien entendu qu'il reçoit ou fournit un ou des signaux représentatifs de ce nombre.

La figure représente un synthétiseur de fréquence à division fractionnaire comportant un certain nombre de circuits en plus d'un synthétiseur de fréquences à division fractionnaire classique ; par synthétiseur classique il faut entendre un synthétiseur destiné à fournir un signal de sortie à fréquence donnée, choisie grâce à des valeurs affichées aux entrées de ce synthétiseur. Dans la description qui suit, la partie « synthétiseur de fréquences à division fractionnaire classique » du synthétiseur selon la figure, sera décrite la première et un rappel du fonctionnement d'un tel synthétiseur sera fait à cette occasion.

La figure représente un oscillateur variable 1, dont la sortie fournit le signal de sortie, à la fréquence $F_S$, du synthétiseur de fréquences. La sortie de l'oscillateur variable 1 est reliée à l'entrée de signal d'un diviseur à rang variable, 2, dont la commande du rang de division, N, a été symbolisée par une flèche arrivant sur le diviseur et la lettre N à côté de cette flèche.

Le signal de sortie du diviseur 2 est appliqué à l'une des deux entrées de comparaison d'un comparateur de phase 3 qui reçoit sur son autre entrée le signal de sortie à la fréquence $F_R = 480$ kHz d'un oscillateur de référence 6 ; ce dernier signal est obtenu à partir d'un oscillateur à quartz de grande précision.

Le signal de sortie du comparateur de phase 3 est appliqué à l'une des deux entrées d'un sommateur analogique, 4, dont l'autre entrée reçoit le signal élaboré par un accumulateur de phase suivi d'un convertisseur numérique analogique 72 ; l'accumulateur de phase est constitué d'un additionneur numérique 70 et d'un registre tampon 71. L'additionneur 70 reçoit sur une première entrée un signal représentant un nombre G qui sera précisé par la suite ; la sortie de l'additioneur 70 est reliée à l'entrée de signal du registre tampon 71 dont le signal de commande est le signal à la fréquence $F_R$ de l'oscillateur 6. L'additionneur 70 est un additionneur modulo M, où M est un nombre entier (M = 480 dans le cas de l'exemple décrit). L'additionneur 70 comporte une sortie de retenue qui indique le dépassement du compte maximum (M − 1 = 479) ; cette sortie porte le repère (N + 1) ; elle est reliée à une entrée de modification de la valeur du rang de division du diviseur 2. La sortie du registre tampon 71 est reliée d'une part à une seconde entrée de l'additionneur 70 et d'autre part à une entrée du convertisseur numérique-analogique 72 qui reçoit sur une autre entrée munie d'un diviseur de fréquences le signal $F_S$ ; le signal de sortie du convertisseur est, comme il a été indiqué ci-avant, reçu par le sommateur 4.

La sortie du sommateur 4 est connectée à l'entrée d'un filtre de boucle 5 dont la sortie fournit le signal de commande de l'oscillateur variable.

La partie du synthétiseur de fréquences qui a été décrite jusqu'ici, c'est-à-dire celle constituée des blocs 1 à 6 et 70 à 72, constitue un synthétiseur de fréquences à division fractionnaire classique ; son principe de fonctionnement est indiqué ci-après.

La fréquence $F_S$ à obtenir à la sortie de l'oscillateur variable 1 est de la forme

$$F_S = (N + k)F_R$$

où (N + k) est un nombre dont la partie entière est N et la partie décimale k. Cette fréquence $F_S$ n'étant pas égale à N fois la fréquence de référence $F_R$, la comparaison par le comparateur de phase 3 du signal à la fréquence $F_S/N$ donné par le diviseur à rang variable avec le signal à la fréquence $F_R$ fournit un signal représentatif de leur différence de phase, qui va en augmentant (ou en diminuant selon la valeur de k) d'une valeur constante à chaque période $T_R = 1/F_R'$ du moins tant que le rang de division du diviseur 2 est égal à N.

Sur la première entrée de l'additionneur 70 est appliqué le nombre G tel que $G = k \cdot M$ où, comme indiqué plus avant, k est la partie décimale de (N + k) et M le modulo de l'additionneur 70. L'addition modulo M effectuée par l'additionneur 70, au rythme $F_R$ de la commande du registre 71, augmente de la valeur G, à chaque période $T_R'$ le compte de l'additionneur 70. A chaque fois que la capacité maximale de l'additionneur est atteinte ou dépassée, l'additionneur fournit un bit de retenue sur sa sortie de retenue (N + 1), et le diviseur variable 2, pendant la durée $T_R$ de ce bit, a son rang de division qui est augmenté d'une unité et passe donc à N + 1. Ainsi le comparateur de phase qui comparait la phase du signal $F_S/N$ avec celle du signal $F_R$ fournissait, comme il a été indiqué un signal de sortie représentatif de l'écart de phase qui allait en augmentant (ou en diminuant) ; par les passages à N + 1 du rang de division cet écart de phase est résorbé sur une durée égale à $M \cdot T_R$. Il en résulte à la sortie du comparateur de phase 3 un signal en dents de scie, en marches d'escalier. Pour chaque fréquence $F_S'$ le signal donné par le comparateur de phase 3 prend une suite de valeurs discrètes qui dépendent de k = G/M et dont, à chaque instant, la valeur numérique théorique est contenue dans l'accumulateur de phase 70, 71, à un coefficient de proportionnalité près ; un exemple de signal de sortie du comparateur 3 est indiqué sur la figure. Le signal de sortie du compensateur 3 est sommé avec le signal de compensation fourni par le convertisseur numérique-analogique 72. Le signal de compensation est l'opposé du signal de sortie du comparateur 3 lorsque la fréquence $F_S$ est parfaitement asservie à la fréquence $F_R$. Pour assurer la compensation dans toute la plage de variation en fréquence du synthétiseur de fréquences, il est tenu compte de ce que l'amplitude du signal représentatif de la différence de phase (sur la sortie du comparateur de phase 3) est inversement proportionnelle à la fréquence $F_S$ ; pour cela le signal de compensation est rendu proportionnel non seulement au contenu de l'accumulateur de phase mais aussi à la période $1/F_S$ du signal du synthétiseur de fréquences et il est obtenu à partir du signal de sortie du registre tampon et du signal $F_S$ au moyen d'un convertisseur numérique-analogique 72.

Le signal de sortie du convertisseur numérique-analogique 72 est addition dans le sommateur 4 au signal de sortie du comparateur de phase 3 ; le signal fourni par le sommateur 4 est filtré par le filtre de boucle 5 pour servir de signal d'asservissement de l'oscillateur variable 1.

La partie de la figure qui vient d'être décrite correspond à un synthétiseur de fréquences à division fractionnaire classique. Le synthétiseur de fréquences qui a servi de modèle pour cette description est destiné à fournir une fréquence de sortie allant de 51,4 à 109,5 MHz par pas, P, de IkHz (P = $F_R$/M = IkHz) et grâce à des valeurs de N comprises entre 107 et 227.

Dans un synthétiseur de fréquences à division fractionnaire classique le nombre G est un nombre constant pour une valeur $F_S$ donnée du signal de sortie. Dans le cas du synthétiseur de fréquences selon l'invention, le nombre G provient de la somme, effectuée par un additionneur 80, d'un nombre g et d'un nombre dg ; et, si le nombre g est constant, le nombre dg, lui, est un nombre variable, positif ou négatif, représentatif d'une information numérique I à transmettre par modulation.

Le nombre dg, dans le cas de l'exemple décrit, est représentatif d'une information numérique, I, ayant un débit de 16 kilobits poar seconde, correspondant à des bits de 62,5 µS de durée. Cette information est appliquée à l'entrée d'un registre à cinq étages, 90, à entrée série et à sorties parallèles, dont les sorties sont connectées à un premier groupe de cinq entrées d'adressage d'une mémoire fixe 92 (ROM dans la littérature anglo-saxonne).

Un compteur 91, modulo n (n = 30), reçoit sur son entrée de signal le signal de référence à la fréquence $F_R$ ; il fournit à un second groupe de cinq entrées d'adressage de la mémoire fixe 92, un nombre dont la valeur varie de 0 à 29 pendant un temps égal à la durée d'un bit d'information puisque la fréquence de référence $F_R$ et le modulo du compteur 91 ont été choisis pour qu'un cycle complet de comptage dure 62,5 µS ($30 \cdot T_R$ = 30/480 000 = 62,5 µS). Les signaux d'affichage reçus par la mémoire fixe 92 sont ainsi d'une part la représentation des cinq derniers bits de l'information I reçue et d'autre part les repères pour l'échantillonnage en trente échantillons de durée $T_R$ des bits d'information. La configuration des cinq derniers bits d'information et le numéro d'échantillon reçus à un instant donné par la mémoire fixe 92 correspondent à un mot de huit bits stocké dans cette mémoire. Ce mot de huit bits est le nombre dg fourni à l'additionneur 80. Etant donné que si dg est nul en permanence g correspond à une fréquence donnée $F_S$ à la sortie de l'oscillateur variable, cette valeur dg peut être considérée comme un incrément de fréquence. Cet incrément de fréquence est envoyé sur l'accumulateur de phase 70-71 et le signal de sortie du synthétiseur de fréquences à division fractionnaire devient $F_S$ + (dg/M) · $F_R'$ c'est-à-dire que $F_S$ subit une variation de phase, durant la durée $T_R$ d'un échantillon, égale à 2 dg/M · $F_R$ · $T_R$ = 2 dg/M.

Dans la mémoire 92, en fonction du numéro d'échantillon, sont stockées des valeurs dg telles que, pour un bit d'information, la somme des variations de phase dues à chaque échantillon correspond à une variation de phase prédéterminée du signal $F_S$ durant ce bit d'information.

Les trente valeurs, dg, stockées correspondant aux trente échantillons relatifs à chaque configuration de cinq bits consécutifs, sont représentatives d'une loi de modulation de phase prédéterminée pour cette configuration. Les trente-deux lois de phase correspondant aux trente-deux configurations de cinq bits sont obtenues par simulation sur calculateur en fonction du type de modulation à obtenir et en tenant compte du temps de réaction de la boucle d'asservissement du synthétiseur de fréquences afin d'optimiser le spectre du signal $F_S$ modulé. Ceci présente l'avantage d'une part d'éliminer le filtre analogique qu'il aurait fallu mettre à l'entrée d'un modulateur angulaire classique pour limiter le spectre du signal modulé, et d'autre part d'effectuer un traitement d'optimisation du spectre difficilement réalisable dans les dispositifs de modulation classiques.

Bien entendu, il est nécessaire, pour que cette modulation ait un sens, que le temps de positionnement en phase de la boucle du synthétiseur de fréquences, pour les incréments dg considérés, soit nettement inférieur à la durée d'un bit de l'information I ; dans l'exemple de réalisation, le temps de positionnement de la boucle est de l'ordre du cinquième de la durée d'un bit.

Il est à noter que le registre 90 et le compteur 91 comportent une entrée de remise à zéro, qui est sensibilisée au début de chaque nouvelle transmission d'informations par un signal Z de remise à zéro.

Il est à remarquer que l'accumulateur de phase, 70-71 suivi du convertisseur 72, ne peut donner un signal de compensation que si G est supérieur à zéro et inférieur au modulo, M, de l'additionneur 70 puisque le signal de compensation est obtenu à partir des circuits 70, 71, qui ne donnent un signal de sortie ayant un sens pour la boucle d'asservissement que si leur signal d'entrée, G, est supérieur à zéro et inférieur au modulo de l'additionneur 70. C'est pourquoi l'additionneur 80 est suivi d'un circuit de décodage 81 qui, lorsque g + dg est inférieur à 0 (c'est-à-dire lorsque dg est négatif et supérieur en valeur absolue à g), fournit à l'additionneur 70 un signal G = M + g + dg et diminue d'une unité le rang de division du diviseur variable 2 ; lorsque g + dg est supérieur à M le circuit de décodage 81 fournit à l'additionneur 70 un signal G = g + dg − M et augmente d'une unité le rang de division du diviseur variable 2. Les sorties du circuit de décodage 81 qui permettent de réduire ou d'augmenter d'une unité le rang de division du diviseur variable 2 ont été repérées par (N ± 1) sur la figure.

La présente invention n'est pas limitée à l'exemple décrit ; c'est ainsi que l'échantillonnage du signal d'information numérique I, grâce au compteur 91, peut être supprimé mais il n'y a plus la possibilité d'optimiser de manière peu coûteuse le spectre du signal transmis par modulation. Il faut alors, pour réaliser cette optimisation du spectre, recourir à des filtres à bande étroite disposés hors de la boucle d'asservissement et recevant le signal de sortie de l'oscillateur variable 1 ; cette solution est généralement impraticable dans la mesure où à chaque fréquence de sortie $F_S$ doit correspondre un filtre.

Il est également possible de modifier le synthétiseur de fréquence modulable selon la figure de façon à lui permettre de traiter une information numérique I ayant un débit différent de 16 k.bits/seconde. Il faut alors que le modulo du compteur 91 qui détermine le nombre d'échantillons par bit d'information, soit commandé en fonction du débit des bits de l'information I reçue pour que, pendant la durée d'un bit, il y ait un nombre entier d'échantillons de durée $T_R$ ; ceci, nécessite d'une part que la valeur en hertz de la fréquence de référence $F_R$ soit divisible par la valeur en bits par seconde du débit de l'information, le quotient de la division donnant le modulo du compteur 91, et d'autre part qu'un dispositif de commutation permette de modifier le modulo du compteur 91 en fonction du débit de l'information numérique reçue.

L'échantillonnage, au lieu d'être effectué à la fréquence $F_R'$ peut être effectué à une fréquence $F_R'$ sous-multiple de $F_R$ et tout ce qui a été dit dans le paragraphe précédent reste valable en y remplaçant $F_R$ par $F_R'$ ; toutefois l'utilisation d'une fréquence d'échantillonnage sous multiple de $F_R$ conduit à définir la loi de phase avec moins d'échantillons et donc avec moins de précision.

Dans le cas où le débit de l'information n'est pas un sous-multiple exact de la fréquence de référence, mais en est très peu différent, il est possible de resynchroniser le débit binaire avec $F_R$, mais cette opération introduit périodiquement une gigue (jitter dans la littérature anglo-saxonne) sur la durée du bit d'information I égale à la durée d'un échantillon, dont il faut tenir compte dans le fonctionnement du compteur 91 par augmentation ou diminution d'une unité du modulo n de ce compteur.

Différentes simplifications peuvent être apportées à la figure dans la mesure où les caractéristiques de la modulation à effectuer et de l'information à moduler sont simplifiées par rapport à celles dont il a été question lors de la description de la figure. C'est ainsi qu'en plus de la suppression de l'échantillonnage dont il a été question plus avant, et qui correspond à la suppression du compteur 91, il est également possible de supprimer le registre 90 et la mémoire 92 dans le cas où l'information I peut directement être prise comme signal de modulation du nombre g, c'est-à-dire dans le cas où la modulation de g est une modulation par tout ou rien avec dg = I.

De même, dans la mesure où g + dg est toujours positif et inférieur, M, de l'additionneur 70, le circuit décodeur 81 devient inutile, la sortie de l'additionneur 80 fournit directement le signal G à l'additionneur 70 et la liason (N ± 1) vers le diviseur variable 2 n'a plus lieu d'être.

L'information numérique modulante, dg, appliquée à l'entrée de l'additionneur 80 peut, dans certaines variantes, provenir d'une information analogique du type parole, par exemple. Dans le cas où l'information, à l'origine, se présente sous forme analogique, des circuits d'échantillonnage et de conversion analogique-numérique permettront de la transformer en une information numérique pour constituer l'information modulante dg.

## Revendications

1. Synthétiseur de fréquences à division fractionnaire pour fournir un signal de sortie de la forme $F_S = (N + k)F_R'$ où N est la partie entière d'un nombre N + k et $F_R$ la fréquence d'un signal de référence, comportant : un oscillateur variable (1) ; une boucle d'asservissement de l'oscillateur variable, comprenant, en série, un diviseur à rang variable (2) prépositionné sur le rang de division N, un comparateur (3) de la phase du signal de sortie du diviseur avec celle du signal de référence, un sommateur (4) et un filtre (5) ; un accumulateur de phase (70, 71), constitué d'un additionneur (70) et d'un registre tampon (71) pour, à la fréquence $F_R'$ sommer modulo M un nombre G = k · M appliqué sur son entrée, et dont les sorties de somme et de retenue sont respectivement couplées au sommateur (4) pour fournir un signal de compensation, et au diviseur (2) pour fournir un signal de commande à N + 1 du rang de division ; et un additionneur (80) ayant une sortie couplée à l'entrée de l'accumulateur de phase, cet additionneur recevant un nombre constant g sur une entrée et un nombre dg représentatif d'une information numérique sur une autre entrée, caractérisé en ce que, pour que le synthétiseur soit aussi le modulateur d'un émetteur à modulation angulaire, modulé par une information numérique, le nombre dg est une information numérique à émettre.

2. Synthétiseur de fréquences selon la revendication 1, caractérisé en ce que l'additionneur (80) est couplé à l'entrée de l'accumulateur de phase (70, 71) par un circuit décodeur (81) qui a une sortie connectée au diviseur variable (2), le circuit décodeur ayant pour rôle, d'une part de délivrer le nombre G sous la forme G = M + g + dg et de commander une diminution d'une unité du rang de division du diviseur variable dans le cas où g + dg est inférieur à zéro et d'autre part de délivrer le nombre G sous la forme G = g + dg − M et de commander une augmentation d'une unité du rang de division du diviseur variable dans le cas où g + dg est supérieur à M.

3. Synthétiseur de fréquences selon la revendication 1, caractérisé en ce que l'information numérique est appliquée à l'entrée d'un registre série-parallèle (90) dont les sorties sont couplées à des entrées d'adressage d'un mémoire (92) programmée en fonction de la loi de modulation à obtenir et couplée à l'additionneur pour lui fournir le nombre dg.

4. Synthétiseur de fréquences selon la revendication 3, caractérisé en ce que l'information numérique est échantillonnée en un nombre entier, n, d'échantillons par bits, et en ce que, pour cela, d'une part la valeur en hertz de la fréquence $F_R$ est égale à n fois la valeur en bits par seconde du débit de l'information numérique, et d'autre part le synthétiseur de fréquences comporte un compteur (91) modulo qui reçoit sur son entrée de comptage le signal de référence et dont les sorties sont couplées à d'autres entrées d'adressage de la mémoire (92).

**Claims**

1. Fractional division-frequency synthesizer for supplying an output signal in the form $F_S = (N + k)F_R'$ wherein N is the integer portion of a number N + k and $F_R$ is the frequency of a reference signal, comprising : a variable oscillator (1) ; a loop controlling the variable oscillator, including, in series, a variable order divider (2) prepositioned at division order N, a comparator (3) for comparing the phase of the output signal of the divider to that of said reference signal, a summarizer (4) and a filter (5) ; a phase accumulator (70, 71) constituted by an adder (70) and a buffer register (71), for summarizing, at the frequency $F_R$, in accordance with modulus M a number $G = k \cdot M$ applied to its input terminal, while its adding and substracting outputs are coupled respectively to the summarizer (4) for supplying a compensation signal, and to the divider (2) for supplying a control signal at N + 1 of the division order ; and an adder (80) an output terminal of which is coupled to the input terminal of said phase accumulator, said adder receiving a constant number g at one input terminal and at another input terminal a number dg representing a digital information, characterized in that said number dg is a digital information to be emitted, so that said synthesizer constitutes also the modulator of an angular modulation transmitter.

2. Frequency synthesizer according to claim 1, characterized in that said adder (80) is coupled to the input terminal of said phase accumulator (70, 71) through a decoding circuit (81) an output terminal of which is connected to said variable divider (2), said decoding circuit being adapted, on the one hand, to supply the number G in the form $G = M + g + dg$ while ordering a one-unit decrease of the division order of said variable divider when g + dg is smaller than zero and, on the hand, to supply the number G in the form $G = g + dg - M$ while ordering a one-unit increase of the division order of said variable divider when g + dg is greater than M.

3. Frequency synthesizer according to claim 1, characterized in that the digital information is applied to the input terminal of a series-parallel register (90) the output terminals of which are coupled to the addressing input terminals of a memory (92) which is programmed in accordance with the modulation law to be obtained, and which is coupled to the adder for supplying the number dg thereto.

4. Frequency synthesizer according to claim 3, characterized in that the digital information is sampled by an integer number n of samples by bits, and in that for this purpose, on the one hand, the value in Hertz of said frequency $F_R$ equals n times the value in bits by second of the flow of digital information and, on the other hand, the frequency synthesizer comprises a modulus n counter (91) which receives at its counting input terminal the reference signal and the output terminals of which are couplet to other addressing input terminals of said memory (92).

**Patentansprüche**

1. Bruchteilungsfrequenzsynthesierer zur Erzeugung eines Ausgangssignals der Form $F_S = (N + k)F_R'$ wo N der ganzzahlige Anteil einer Grösse N + k darstellt, während $F_R$ die Frequenz eines Bezugssignals ist, umfassend : einen steuerbaren Oszillator (1) ; eine den steuerbaren Oszillator steuernde Steuerschleife, welche in Reihenschaltung angeordnet aufweist ; einen Teiler mit veränderlichem Teilungsrang (2), der auf den Teilungsrang N voreingestellt ist, einen die Phase des Ausgangssignals des Teilers mit derjenigen des Bezugssignals vergleichenden Komparator (3), einen Summierer (4) und ein Filter (5) ; einen aus einem Addierer (70) und einem Pufferregister (71) bestehenden Phasenspeicher (70, 71), der bei der Frequenz $F_R$ gemäss Modul M einen an seinen Eingang gelegten Wert $G = k \cdot M$ summiert und dessen Summier- und Subtrahierausgänge zwecks Erzeugung eines Kompensationssignals an den Summierer, bzw. zwecks Erzeugung eines Steuersignals mit dem Teilungsrang N + 1 an den Teiler angekoppelt werden ; sowie einen Addierer (80) mit einem an den Eingang des Phasenspeichers angeschlossenen Eingang, wobei dieser Addierer an einem Eingang eine konstante Grösse g und an einem anderen Eingang eine Grösse dg empfängt, die einer numerischen Information entspricht, dadurch gekennzeichnet, dass die Grösse dg eine abzugebende numerische Information ist, damit der Synthesierer auch als Modulator eines durch eine numerische Information modulierten Senders mit Winkelmodulation arbeitet.

2. Frequenzsynthesierer nach Anspruch 1, dadurch gekennzeichnet, dass der Addierer (80) an den Eingang des Phasesnspeichers (70, 71) über einen Entschlüsselungskreis (81) angeschlossen ist, von dem ein Ausgang mit dem veränderlichen Teiler (2) verbunden ist, wobei der Entschlüsselungskreis dazu bestimmt ist, einerseits die Grösse G in der Form $G = M + g + dg$ abzugeben und wenn g + dg kleiner als null ist, den Teilungsrang des veränderlichen Teilers um eine Einheit herabzusetzen, sowie andererseits die Grösse G in der Form $G = g + dg - M$ abzugeben und wenn g + dg grösser als M ist, den Teilungsrang des veränderlichen Teilers um eine Einheit zu erhöhen.

3. Frequenzsynthesierer nach Anspruch 1, dadurch gekennzeichnet, dass die numerische Information an den Eingang eines Serien-Parallel-Registers (90) gelegt ist, dessen Ausgänge an die Adressiereingänge eines Speichers (92) angeschlossen sind, der nach Massgabe der zu erzielenden Modulationsfunktion programmiert und mit dem Addierer verbunden ist, um an ihn die Grösse dg zu übertragen.

4. Frequenzsynthesierer nach Anspruch 3, dadurch gekennzeichnet, dass die numerische Information auf der Basis einer ganzzahligen Anzahl n von Bitsprobenahmen bemustert wird, und dass zu diesem Zweck einerseits der in Hertz ausgedrückte Wert der Frequenz $F_R$ gleich dem n-fachen Wert von Bits pro Sekunde der Abgabe der numerischen Information ist und andererseits der Frequenzsynthesierer einen Zahler (91) mit einem Modul n besitzt, der an seinem Zähleingang das Bezugssignals empfängt und dessen Ausgänge an andere Adressiereingänge des Speichers (92) angeschlossen sind.